(19) Europäisches Patentamt

European Patent Office

Office européen des brevets

(11) EP 0 364 170 B1

## (12) EUROPEAN PATENT SPECIFICATION

(45) Date of publication and mention
of the grant of the patent:
**18.09.1996 Bulletin 1996/38**

(51) Int Cl.6: **H03M 5/14**, H03M 5/12,
H04L 25/49

(21) Application number: **89310250.9**

(22) Date of filing: **06.10.1989**

(54) **High speed serial data link**

Serielle Übertragungsstrecke für hohe Datenraten

Liaison de données en série à grand débit

(84) Designated Contracting States:
**DE FR IT NL**

(30) Priority: **12.10.1988 US 256954**

(43) Date of publication of application:
**18.04.1990 Bulletin 1990/16**

(73) Proprietor: **TEXAS INSTRUMENTS
INCORPORATED
Dallas Texas 75265 (US)**

(72) Inventors:
• **Bryans, Mark A.
Dallas Texas 75229 (US)**
• **Cline, James H.
Allen Texas 75002 (US)**
• **Frazee, Francis B.
Plano Texas 75075 (US)**
• **Lehman, Lark Edward
Colorado 80908 (US)**

(74) Representative: **Abbott, David John et al
Abel & Imray
Northumberland House
303-306 High Holborn
London, WC1V 7LH (GB)**

(56) References cited:
**EP-A- 0 201 935**

• **IBM TECHNICAL DISCLOSURE BULLETIN, vol.
29, no. 2, July 1986, page 888, New York, US;
"Signal encoding for fiber-optic link"**
• **PATENT ABSTRACTS OF JAPAN, vol. 9, no. 318
(E-366)[2041], 13th December 1985; & JP-A-60
152 155**
• **PATENT ABSTRACTS OF JAPAN, vol. 1, no. 38
(E-76)[2318], 4th April 1977; & JP-A-51 136 223**

## Description

## BACKGROUND AND SUMMARY OF THE INVENTION

The present invention relates generally to communication systems, and more specifically to a method and device for transmitting serial data at very high speeds.

Transferring high speed digital signals between various parts of a computer system, or between systems, is a common requirement. In order to increase bandwidth, parallel data transmission is used wherever possible. However, due to cost, weight, interference (noise), and electrical loading considerations, parallel transmission is not feasible for many systems. In order to simplify the communications problem, data can be transmitted serially. This requires less hardware for the actual communications link. However, parallel data must be converted to serial form for the transmission. The bit rate for the transmission of serial data must be much higher than that required to transmit data in parallel form.

This high bit rate requirement has limited the usefulness of the serial data link in high speed communications systems in the past. However, faster bit rates are becoming available with current technology, and the use of fiber optics as the transmission medium holds the promise of much higher bit rates in the future. Current fiber optic transmission and reception hardware is quite complex, requiring a large number of integrated circuits for each function. Such implementations are not practical in low cost systems, or in some systems having severe weight and space restrictions, such as on board an aircraft or a satellite.

It would be desirable for a serial data link using fiber optic communications to utilize high bit rate data transmission, and to be realizable in a small number of relatively inexpensive integrated circuits.

IBM Technical Disclosure Bulletin, Vol. 29 No. 2 July 1986 describes a method of coding a data stream in a manner that enables a clock signal to be recovered at the receiving end. The start and end of an information frame are indicated by a flag consisting of six consecutive "1" bits. If there is a succession of six or more consecutive "1" bits in the frame to be transmitted, a "0" bit is inserted after five consecutive "1" bits. The bit stream is coded using "non-return to zero inverted" coding.

EP 0 201 935 relates to a method and circuit for suppressing sequential zeros in data for transmission to enable recovery of the clock signal. When the circuit detects sequential zeros in a frame of data, a data bit "1" is inserted into the frame per every "m" bits of data. Data bits displaced from the frame as a result of the insertion of "1"s, are included in the next frame.

The present invention provides a method for transmitting and receiving data comprising a plurality of data words via a medium having a maximum time between data transitions of $T_{max}$ and a minimum time between data transitions of $T_{min}$, each data word being composed of a plurality of 1's and 0's, including forming a prepended data word by prepending a unique signal to each data word for indicating the start of a transmitted data word, serially transmitting data words one bit at a time each transmitted bit having a uniform length greater than $T_{min}$, receiving said serially transmitted data words, searching received data for said unique signal, and removing said unique signal from the received data words, characterised in that the method comprises: selecting a maximum number of permitted consecutive 1's, whereby the maximum number of permitted consecutive 1's in a data word are transmitted in a time of less than $T_{max}$; selecting a maximum number of permitted consecutive 0's, whereby the maximum number of permitted consecutive 0's in a data word are transmitted in a time of less than $T_{max}$; counting the number of consecutive 1's in each prepended data word for transmission and ensuring transmission of no more than said maximum number of consecutive 1's by inserting 0's into said prepended data word to convert strings of 1's therein longer than the maximum number of consecutive 1's into at least two shorter strings; counting the number of consecutive 0's in each prepended data word for transmission and ensuring transmission of no more than said maximun number of consecutive 0's by inserting 1's into said prepended data word to convert strings of 0's therein longer than said maximum number of consecutive 0's into at least two shorter strings; counting the number of consecutive 1's in the received data words and removing a next bit following the receipt of said maximum number of consecutive 1's; and counting the number of consecutive 0's in the received data words and removing a next bit following receipt of said maximum number of consecutive 0's.

The invention also provides a method for transmitting data comprising a plurality of data words via a medium having a maximum time between data transitions of $T_{max}$ and a minimum time between data transitions of $T_{min}$, each data word being composed of a plurality of 1's and 0's, including forming a prepended data word by prepending a unique signal to each data word for indicating the start of a transmitted data word, and serially transmitting data words one bit at a time each transmitted bit having a uniform length greater than $T_{min}$, comprising: selecting a maximum number of permitted consecutive 1's, whereby the maximum number of permitted consecutive 1's in a data word are transmitted in a time of less than $T_{max}$; selecting a maximum number of permitted consecutive 0's, whereby the maximum number of permitted consecutive 0's in a data word are transmitted in a time of less than $T_{max}$; counting the number of consecutive 1's in each prepended data word for transmission and ensuring transmission of no more than said maximum number of consecutive 1's by inserting 0's into said prepended data word to convert strings of 1's therein longer than the maximum number of consecutive 1's into at least two shorter strings; and counting the number of consecutive 0's in each prepended data word for transmission and ensuring transmission of no more than said maximum number of consecutive 0's by inserting 1's into said prepended data word to convert strings of 0's therein longer than said maximum number of consecutive 0's into at least two shorter strings.

The invention also provides a method for receiving data comprising a plurality of data words via a medium having a maximum time between data transitions of $T_{max}$ and a minimum time between data transitions of $T_{min}$, each data word being composed of a plurality of 1's and 0's and having a unique signal to each data word for indicating the start of a transmitted data word prepended thereto, receiving said serially transmitted data words, searching received data for said unique signal, and removing said unique signal from the received data words, comprising: selecting a maximum number of permitted consecutive 1's, whereby the maximum number of permitted consecutive 1's in a data word are transmitted in a time of less than $T_{max}$; selecting a maximum number of permitted consecutive 0's, whereby the maximum number of permitted consecutive 0's in a data word are transmitted in a time of less than $T_{max}$; counting the number of consecutive 1's in the received data words and removing a next bit following the receipt of said maximum number of consecutive 1's; and counting the number of consecutive 0's in the received data words and removing a next bit following receipt of said maximum number of consecutive 0's.

The invention further provides a system for transmitting and receiving data comprising a plurality of data words via a medium having a maximum time between data transitions of $T_{max}$ and a minimum time between data transitions of $T_{min}$, each data word composed of a plurality of 1's and 0's, including means for forming a prepended data word by prepending a unique signal to each data word for indicating the start of a transmitted data word, means for serially transmitting data words one bit at a time each transmitted bit having a uniform length greater than $T_{min}$, means for receiving said serially transmitted data words, means for searching received data for said unique signal, and removing said unique signal from the received data words, characterised in that the system comprises means for counting the number of consecutive 1's in each prepended data word for transmission and for ensuring transmission of no more than a maximum number of consecutive 1's by inserting 0's into said prepended data word to convert strings of 1's therein longer than the maximum number of consecutive 1's into at least two shorter strings, the maximum number of permitted consecutive 1's, having been chosen so that the maximum number of permitted consecutive 1's in a data word are transmitted in a time of less than $T_{max}$; means for counting the number of consecutive 0's in each prepended data word for transmission and for ensuring transmission of no more than said maximum number of consecutive 0's by inserting 1's into said prepended data word to convert strings of 0's therein longer than said maximum number of consecutive 0's into at least two shorter strings; the maximum number of permitted consecutive 0's, having been chosen so that the maximum number of permitted consecutive 0's in a data word are transmitted in a time of less than $T_{max}$; means for counting the number of consecutive 1's in the received data words and for removing a next bit following the receipt of said maximum number of consecutive 1's; and means for counting the number of consecutive 0's in the received data words and removing a next bit following receipt of said maximum number of consecutive 0's in the received data words and removing a next bit following receipt of said maximum number of consecutive 0's.

Also, the invention provides a system for transmitting data comprising a plurality of data words via a medium having a maximum time between data transistions of $T_{max}$ and a minimum time between data transistions of $T_{min}$, each data word being composed of a plurality of 1's and 0's, including means for forming a prepended data word by prepending a unique signal to each data word for indicating the start of a transmitted data word, and means for serially transmitting data words one bit at a time each transmitted bit having a uniform length greater than $T_{min}$, characterised in that the system comprises means for counting the number of consecutive 1's in each prepended data word for transmission and for ensuring transmission of no more than a maximum number of consecutive 1's by inserting 0's into said prepended data word to convert strings of 1's therein longer than the maximum number of consecutive 1's into at least two shorter strings, the maximum number of permitted consecutive 1's, having been chosen so that the maximum number of permitted consecutive 1's in a data word are transmitted in a time of less than $T_{max}$; means for counting the number of consecutive 0's in each prepended data word for transmission and for ensuring transmission of no more than a maximum number of consecutive 0's by inserting 1's into said prepended data word to convert strings of 0's therein longer than said maximum number of consecutive 0's into at least two shorter strings, the maximum number of permitted consecutive 0's, having been chosen so that the maximum number of permitted consecutive 0's in a data word are transmitted in a time of less than $T_{max}$.

The invention also provides a system for receiving data comprising a plurality of data words via a medium having a maximum time between data transitions of $T_{max}$ and a minimum time between data transitions of $T_{min}$, each data word composed of a plurality of 1's and 0's and having a unique signal to each data word for indicating the start of a transmitted data word prepended thereto, means for receiving said serially transmitted data words, means for searching received data for said unique signal, and removing said unique signal from the received data words, characterised in that the system comprises means for counting the number of consecutive 1's in the received data words and for removing a next bit following the receipt of a maximum number of consecutive 1's; the maximum number of permitted consecutive 1's, having been chosen so that the maximum number of permitted consecutive 1's in a data word are transmitted in a time of less than $T_{max}$; means for counting the number of consecutive 0's in the received data words and for removing a next bit following receipt of said maximum number of consecutive 0's, the maximum number of permitted consecutive 0's, having been chosen so that the maximum number of permitted consecutive 0's in a data word are transmitted in a time of less than $T_{max}$.

The novel features which characterize the present invention are defined by the appended claims. The foregoing and other objects and advantages of the present invention will hereafter appear, and for purposes of illustration, but not of limitation, a preferred embodiment is shown in the accompanying drawings.

## BRIEF DESCRIPTION OF THE DRAWINGS

Figure 1 is a block diagram of a communications system which utilizes the present invention;

Figure 2 is a block diagram of an encoder which encodes data for transmission according to the present invention;

Figure 3 is a block diagram of a decoder which decodes received data according to the present invention;

Figure 4 is a flow chart illustrating an encoding scheme useful with the present invention;

Figure 5 is a flow chart illustrating a decoding scheme suitable for use with the present invention; and

Figure 6 is a block diagram of an alternative embodiment of a serial communication system.

## DESCRIPTION OF THE PREFERRED EMBODIMENTS

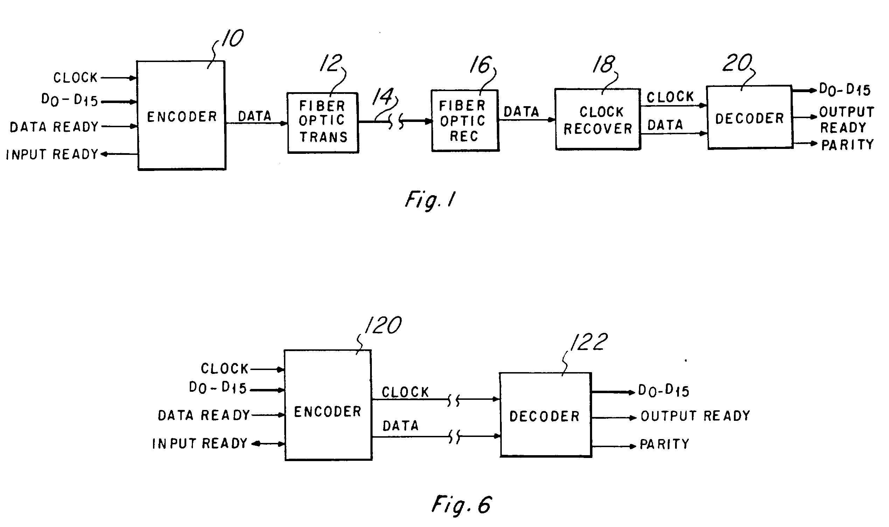

Figure 1 shows a serial communications link suitable for transmitting data between two parallel devices. The following description assumes that data word width of the parallel devices is 16 bits; however, other word widths can be used as will become apparent to those skilled in the art in conjunction with the following description.

A 16 bit data word is presented to an encoder device 10 on lines $D_0$ - $D_{15}$. A CLOCK signal is also presented to the encoder device 10. The encoder device 10 converts the data from parallel to serial form, and sends it to a fiber optic transmitter 12. The data is transmitted along a fiber optic cable 14 to a fiber optic receiver 16, which presents digital data to a clock recover circuit 18. The clock recover circuit 18 extracts the clock from the data itself, and presents both the CLOCK and the DATA signals to a decoder circuit 20. The decoder circuit 20 converts the serial data into parallel form, and outputs it on data lines $D_0$ - $D_{15}$.

When the encoder circuit 10 is ready to accept a parallel data word for conversion, it signals its status on the INPUT READY line. When the parallel system (not shown) is ready, that is, the data on the input data lines $D_0$ - $D_{15}$ is valid, the DATA READY line is signalled. At that time, the encoder circuit 10 begins the parallel to serial conversion and transmission.

In a similar manner, the decoder circuit 20 signals on the OUTPUT READY line when it has received a complete data word. In addition, in order to decrease communication sensitivity to noise, a PARITY signal is output from decode circuit when a parity error is detected in transmission.

The fiber optic link used in the system just described has relatively severe bandwidth restrictions. These bandwidth restrictions place certain requirements on the data which is transmitted, and such requirements are met by encoding the data prior to transmission as will be described below. In addition, the system is preferably operated asyncronously, requiring that a sync pulse be transmitted along the serial link prior to transmission of each data word.

As is known in the art, the amplifiers associated with fiber optics data linis can be viewed as band pass filters; they have a low speed limitation as well as a high speed limitation. Typical amplifiers must be operated so that the maximum time between a data transition (0.1, or 1.0) falls within a well defined range. This can be expressed as

$$T_{min} < T < T_{max}$$

where $T_{min}$ is the minimum length of time between data transitions, and $T_{max}$ is the maximum time between transitions.

Most fiber optic systems are capable of handling a large enough bandwidth that the ratio of $T_{max}/T_{min}$ is 6:1. $T_{min}$ occurs when a string of alternating 0's and 1's are transmitted. $T_{max}$ is a consideration when a long string of consecutive 0's or 1's are transmitted. For the desired ratio of 6:1, the transmitted data must be encoded so that no more than five consecutive 0 bits are transmitted, and that no more than five consecutive 1's are transmitted. It is also necessary that a unique sync signal be communicated which cannot be the same as the transmission of any possible data sequence. The data encoding scheme which will now be described meets these constraints.

The preferred data encoding scheme uses insertion of 1's and 0's in order to break up long data strings. Thus, whenever five consecutive 0's are transmitted, the encoder inserts a 1, not used as a data bit, in order to ensure that the $T_{max}$ restriction is met. Likewise, no more than five consecutive 1's are allowed.

A preferred sync signal consists of 11110. This is the most efficient length for the sync signal for a 16 bit word width, although other lengths could be used with this technique. Larger word widths, such as 32 bits, can use the same sync signal, or others as may be required by the specific situation at hand.

The signal 11110 will always be read by the decoder circuit 20 as a sync signal. Therefore it is necessary that transmitted data never contain more than 3 consecutive 1's. This is accomplished by a simple counter included as part of the encoder 10 circuitry, which, when three consecutive data 1's have been transmitted, inserts a 0 regardless of the value of the next data bit. When the decoder circuitry 20 receives three consecutive 1's followed by a 0, it knows that the trailing 0 is always for encoding purposes only and discards it. Three consecutive 1's followed by a fourth 1 always signals the presence of a sync signal.

In a similar manner, the encoder circuitry 10 counts the number of consecutive 0's that have been transmitted, be they data bits, the trailing 0 of the sync signal, or 0's inserted after three consecutive 1's. After five consecutive 0's of any type have been transmitted, a 1 is always inserted into the data stream. As before, this one is for encoding purposes only, and is never a data bit. The decoder circuitry 20, after receiving five consecutive 0's, always discards the 1 which is received next.

It will be appreciated that the insertion of extra 1's and 0's increases the length of the transmitted data word. This overhead is the price which must be paid in order to ensure accurate data transmission.

Also, in order to properly recognize the sync signal, each transmitted data word preferably should not end with a 1. Thus, if a 1 is the last bit transmitted for a word, an extra 0 is added to the transmission. This allows the decoder circuitry 20 at the receiving end to pick out the following sync signal.

Table 1 shows the encoding of several 16 bit words according to the above scheme. With a sync signal consisting of four 1's followed by a 0, the first three words show the worst case in terms of overhead. That is, more non-data bits are inserted in these three words than in any other 16 bit words which can be transmitted. Since 27 bits must be transmitted for one 16 bit word, the worst case overhead for the above described scheme is, including the sync signal and a parity bit, forty percent. The average overhead for randomly transmitted 16 bit words will, of course, be somewhat lower than this.

TABLE 1

| Data (hex) | Encoded Data |
|------------|--------------|
| FFFF | 11110111011101110111011010 |
| 0C30 | 11110000001110000011100000010 |
| E186 | 1111011100000111000000111000 |
| 1357 | 1111000010011010101110 |
| 0AF4 | 1111000001101011101010100 |

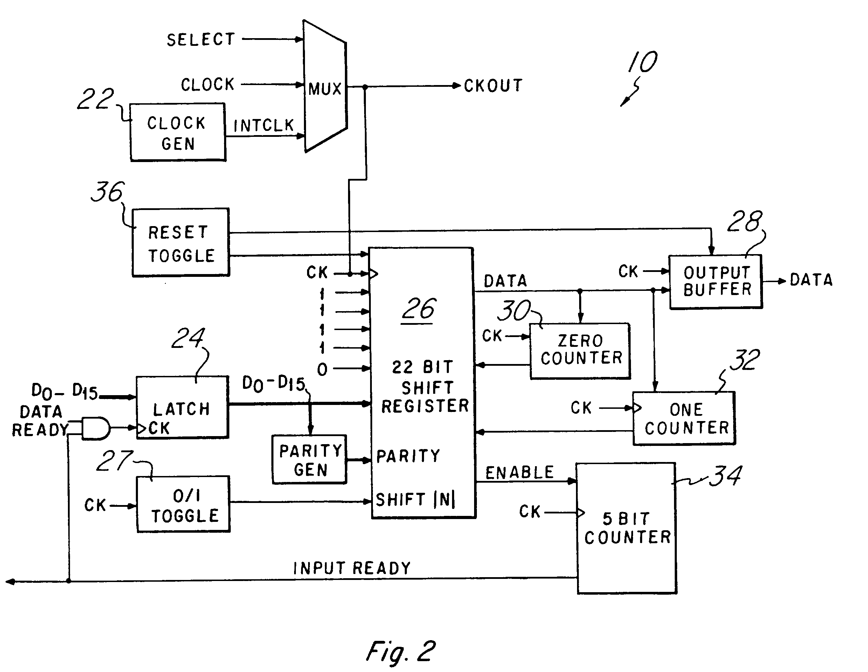

Referring to Figure 2, a block diagram for the encoder 10 is shown. The clock signal CK to be used can be generated internally as signal INTCLK in a clock generating circuit 22, or provided externally as the signal clock. A SELECT signal, preferably attached to an input pin of the integrated circuit containing the encoder 10, is used to determine whether the external or internal clock is used. The internal clock 22 can be a simple ring oscillator of the appropriate frequency. Although ring oscillators are typically not extremely well controlled, this does not present a problem since the communication is asynchronous and the receiver will extract the clock signal from the transmitted data. The clock signal CK is used to clock the remainder of the circuitry on the encoder chip 10, and is provided as an output signal CKOUT for systems which require it as will be described in connection with Figure 6.

The input data $D_0$ - $D_{15}$ is held in a latch 24. When the signals INPUT READY and DATA READY are both high, the latch 24 is clocked, and loads its data into a 22 bit shift register 26. Also loaded into the shift register 26 at this time are the sync signal (11110) and a parity bit calculated from the data word. Any parity scheme can be used, with a single bit even parity scheme used in the preferred embodiment.

Also connected to the shift register 26 is a 0/1 toggle 27, typically a flip flop, which generates a continuous string of alternating 0's and 1's to be shifted into the register 26 for reasons which are described below.

Once the data has been loaded into the shift register 26, it is shifted out serially to an output buffer 28, which communicates the bit stream to the fiber optic transmitter 12.

A 0 counter 30 and a 1 counter 32 are connected to the output of the shift register 26, and count, respectively, how many consecutive 0's or 1's have been transmitted. The first four transmitted ones are ignored by the 1 counter 32, since it is known they are the sync signal. Whenever a 0 is encountered, the 1 counter 32 is reset, and whenever a transmitted 1 is encountered, the 0 counter 30 is reset. Beginning with the 0 of the sync pulse, the 0 and 1 counters 30, 32 respectively keep track of the number of 0's and 1's transmitted. Whenever five consecutive 0's are detected by the 0 counter 30, it signals the shift register 26 to cease transmitting data for one clock cycle and to place a 1 in the output data string. Whenever the 1 counter 32 detects three consecutive 1's, it signals the shift register 26 to cease transmitting data for one clock cycle and to place a 0 in the output data string. After insertion of this non-data 0 or 1, the shift register 26 continues shifting data out to the output buffer 28 at the rate of 1 bit per clock cycle.

Twenty two bits are sent by the shift register 26, not including any 0's or 1's inserted as a result of a signal from the 0 counter or 1 counter. These bits include the five sync bits, the 16 data bits and one parity bit. A 5 bit counter 34 is used to count transmission of these twenty two bits in order to determine when the next data word can be loaded into the shift register 26. When the shift register 26 begins shifting the sync signal, an ENABLE signal is sent to the 5 bit counter 34. So long as this ENABLE signal is raised, the 5 bit counter 34 counts up to twenty-two. Whenever a non-data 0 or 1 is transmitted, the ENABLE signal is lowered so that the counter 34 does not increment on that clock cycle. In this manner, the counter 34 does not count the inserted, non-data 0's and 1's sent to the output buffer 28.

After twenty-two sync, data, and parity bits have been sent, the signal INPUT READY is raised, and the encode circuitry 10 is ready to accept another word.

When data is shifted out of the shift register 26, an alternating series of 0's and 1's are shifted in from the 0/1 toggle 27. Thus, when the shift register 26 has shifted out the current data word, it is filled with alternating 0's and 1's. If no next parallel data word is ready to be transmitted as determined by the signal DATA READY, the shift register 26 continues transmitting 0's and 1's to the output buffer 28. This keeps the communication line active, and prevents problems which can occur in the receiver when no transitions (0-1 or 1-0) are transmitted for a time exceeding $T_{max}$. When a new parallel data word becomes available, the DATA READY signal is raised, the value is loaded from the latch 24 into the shift register 26, and the new data word is shifted out. In this manner, a bit is transmitted along the communications channel every clock cycle regardless of whether or not any actual data is being transmitted.

A reset toggle 36, which can be initiated by a reset signal into the integrated circuit or by power up, initializes the output buffer 28, initializes the shift register 26, and causes the five bit counter 34 to be reset. The encoder 10 is then ready to begin receiving data for transmission.

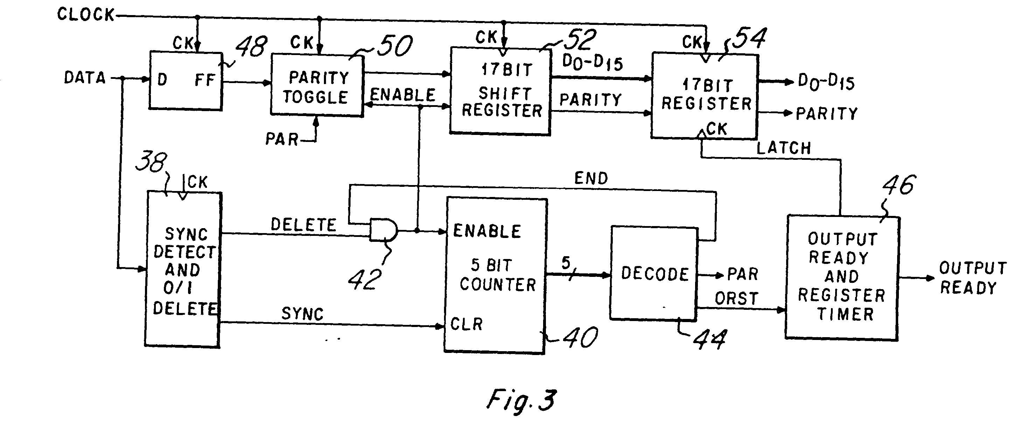

Figure 3 shows a block diagram of the preferred decode circuit 20. In this circuit, the signal CLOCK has already been recovered by the clock recover circuit 18, and is provided to all of the internal circuitry as the signal CK. The incoming DATA stream is applied to a sync detect and 0/1 delete circuit 38. When a sync signal is detected by this circuit 38, it generates a signal SYNC which is used to clear a five bit counter 40. The five bit counter 40 functions to count to twenty-two in the same manner as the counter 34 located in the encode circuitry 10. The sync detect circuit 38 is connected to the ENABLE input of the counter 40 through a DELETE signal and an AND gate 42 to prevent the counter 40 from counting non-data 0's and 1's inserted by the encoder 10.

A decode circuit 44 coupled to the output of the counter 40 provides an END signal which goes low after the count reaches twenty-two, preventing the counter 40 from continuing. After 21 bits are counted, a PAR signal is provided for parity counting purposes as will be described. After twenty-two bits have been counted, an output ready start signal (ORST) is communicated to an output ready and register timer circuit 46. This circuit 46 provides an OUTPUT READY signal which is communicated off chip, and used to indicate that a data word is available to the rest of the computer system (not shown).

The incoming data is also supplied to a D flip flop 48 which delays it for one clock cycle, and then transmits the data to a parity toggle circuit 50. This parity toggle circuit 50 contains a flip flop internally (not shown) which contains a parity bit as currently applied to the data stream. Parity is not calculated when a non-data 0 or 1 is detected by the delete circuit 38, as controlled by the signal ENABLE. The data passes through the parity toggle circuitry 50 into a 17 bit shift register 52. After 21 data bits have been counted by the counter 40, the signal PAR is raised, causing the current value of the parity toggle 50 to be shifted into the last bit of the shift register 52. The shift register 52 now contains 16 data bits and 1 parity bit. On the clock cycle after this parity bit is shifted into the shift register 52, the signal LATCH from the output ready circuitry 46 causes the contents of the shift register 52 to be latched into a 17 bit latch register 54. The data, and parity bit, are now available in parallel form for the remaining circuitry.

The remaining blocks of the diagram of Figure 1 are fairly standard. Fiber optic transmission and receive circuits 12, 16 are known in the art, and any suitable such circuits can be used with the present invention. The clock recover circuitry 18 is also known in the art, and is available as a single chip implementation from several sources.

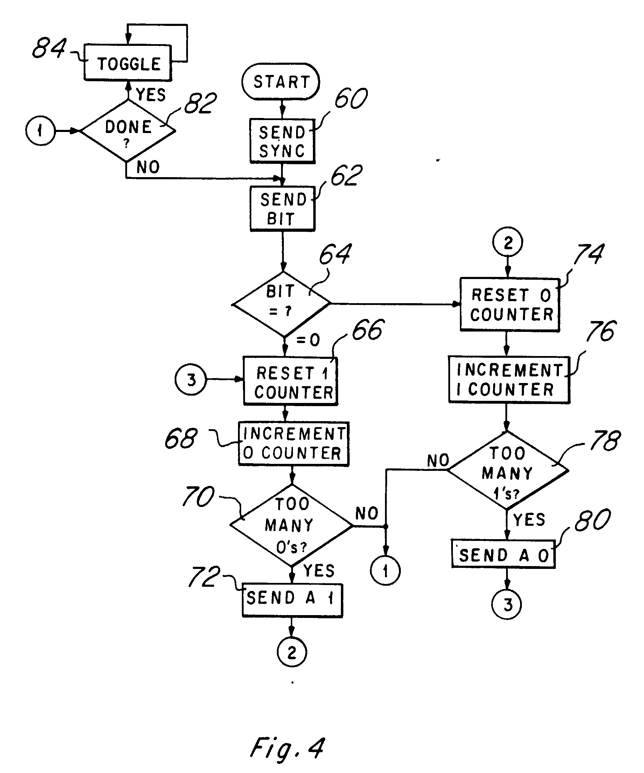

As described above, the shift register circuitry 26 in combination with the 0 counter 30 and 1 counter 36 of the encode circuit 10 performs the data encoding scheme described above. Figure 4 is a flow chart illustrating the logic flow by which this circuitry works.

Referring to Figure 4, when a new data word is loaded into the shift register, a sync signal is sent 60. After the sync signal is sent, the next bit is sent 62. If the bit is a 0 (step 64), the left branch of the chart is taken, and the 1 counter is reset 66. At the same time, the 0 counter is incremented 68. If too many 0's have been sent (step 70), which in the presently described implementation is 5, a 1 is then sent 72, and control flow returns to point 2. If less than this number of 0's have been sent, control flow moves to point 1. If this is the last bit to be sent (step 82), the system toggles 1's and 0's (step 84) until another data word is loaded. If not, the flow of control returns to send the next bit 62.

If the transmitted bit is a 1 (step 64), the right branch of the flow chart is taken, and the 0 counter is reset 74 and the 1 counter is incremented 76. A test is made 78 to see if too many 1's have been transmitted, which, as presently described, is 3. If less than three 1's have been sent, the flow of control returns to point 1. If three 1's have been sent, a non-data 0 is transmitted 80, and the flow of control is returned to point 3.

This flow chart describes the entire data encoding technique. Although, as described in Figure 2, hardware was used to encode the data, it would be possible for software or mixed software/hardware implementations to be made according to the present invention. Hardware is preferred to achieve the very high bit rates desired, and the logic is not difficult to implement.

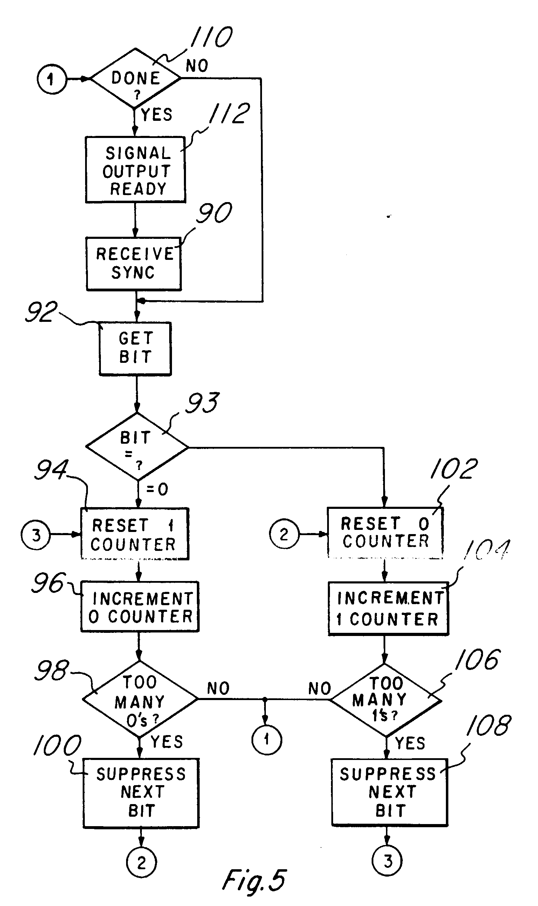

Figure 5 shows a similar logic flow utilized by the decode circuitry. The decoding begins when a sync signal is received 90. After receiving the sync signal, the next bit is obtained 92, and tested 93 to see if it is a 0 or a 1. If the next bit is a 0, the left branch of the flow chart is taken. Internally to the sync detect and 0/1 delete circuitry, a 1 counter is reset 94, a 0 counter is incremented 96, and a test made 98 to see if too many 0's have been received. As described above, the yes branch of this test is taken if five 0's have been received. In this case, the next bit is suppressed 100, signalled by the signal DELETE shown in Figure 3. Control then passes to point 2 of the flow chart. If the result of the bit test 93 is a 1, the 0 counter is reset 102, the 1 counter in incremented 104, and a test made 106 for the number of 1's received. If three 1's have been received, the next bit is suppressed 108 and control passes to point 3 of the flow chart.

In the case of receipt of a 0 or 1, if the number of consecutive 0's or 1's is below the critical limit (steps 98 and 106), control passes to point 1 of the flow chart. If the last bit of this number has been received 110, the output ready signal is raised 112 and the decode circuitry waits for the next sync signal. If all bits have not yet been received, the next one is obtained 92 and checked as described above.

Referring to Figure 6, another embodiment of the serial communication system is shown. This system includes a direct electrical coupling of an encoder 120 and decoder 122. The CLOCK signal is supplied on a separate line from the DATA signal, so that no clock recover circuitry is required. The encode and decode circuitry 120, 122 are identical to the encoder 10 and decoder 20 of Figure 1.

It is also possible to send the clock and data signals separately when using a fiber optic transmission system. This would require either two fiber optic transmit/receive pairs, or two different frequencies of light transmitted along the fiber which can be separated at the receiving end.

With the circuitry described above, a 20 MHz parallel system can communicate data along the serial link adequately if a 500 MHz bit rate is used for the serial data. This is fairly fast, but is easily accomplished by the use of a ring oscillator on the encode circuit 10 as described above. Since communication is asyncronous, a precisely controllable high speed clock is not required. In addition, with the operation of the system described above, a separation is maintained between the high speed serial clock and the lower speed parallel data clock used in the rest of the computer system. With on chip generation of the high speed clock, the parallel system can simply watch for the INPUT READY signal generated by the encode circuitry, and need not be concerned with syncronization of the high speed clock.

The circuitry described above can best be implemented on gallium arsenide integrated circuits, with each of the encode and decode circuitry units being integrated into a single chip. This allows a simple, high speed serial link to be realized at very low cost and with a very low parts count.

The number of consecutive 0's and 1's which are allowed prior to insertion of a non-data 1 or 0 is dependent upon the characteristics of the fiber optic transmit and receive devices. As will be readily apparent to those skilled in the art, the use of both 0 insertion/deletion and 1 insertion/deletion allows the encoding scheme described above to be implemented with the desired characteristics.

The present invention has been illustrated by the system described above, and it will become apparent to those skilled in the art that various modifications and alterations may be made thereto.

## Claims

1. A method for transmitting and receiving data comprising a plurality of data words via a medium having a maximum time between data transitions of $T_{max}$ and a minimum time between data transitions of $T_{min}$, each data word being composed of a plurality of 1's and 0's, including forming a prepended data word by prepending a unique signal to each data word for indicating the start of a transmitted data word (60), serially transmitting data words one bit at a time (62) each transmitted bit having a uniform length greater than $T_{min}$, receiving said serially transmitted data words (92), searching received data for said unique signal (90), and removing said unique signal from the received data words (90), characterised in that the method comprises:

   (a) selecting a maximum number of permitted consecutive 1's, whereby the maximum number of permitted consecutive 1's in a data word are transmitted in a time of less than $T_{max}$;
   (b) selecting a maximum number of permitted consecutive 0's, whereby the maximum number of permitted consecutive 0's in a data word are transmitted in a time of less than $T_{max}$;
   (c) counting the number of consecutive 1's in each prepended data word for transmission (76) and ensuring transmission of no more than said maximum number of consecutive 1's by inserting 0's into said prepended data word (80) to convert strings of 1's therein longer than the maximum number of consecutive 1's into at least two shorter strings;
   (d) counting the number of consecutive 0's in each prepended data word for transmission (68) and ensuring transmission of no more than said maximun number of consecutive 0's by inserting 1's into said prepended data word (72) to convert strings of 0's therein longer than said maximum number of consecutive 0's into at least two shorter strings;

(e) counting the number of consecutive 1's in the received data words (104) and removing a next bit following the receipt of said maximum number of consecutive 1's (106, 108); and

(f) counting the number of consecutive 0's in the received data words (96) and removing a next bit following receipt of said maximum number of consecutive 0's (98, 100).

2. A method for transmitting and receiving data according to claim 1, wherein said unique signal prepended to each data word indicating the start of a transmitted data word consists of an integral number of consecutive 1's that can be transmitted in a time less than $T_{max}$ followed by a single 0, and wherein:

(a) said step of selecting said maximum number of permitted consecutive 1's selects an integral number less than said number of consecutive 1's of said unique signal;

(b) said step of selecting said maximum number of permitted consecutive 0's selects a greatest integral number of consecutive 0's that can be transmitted in a time less than $T_{max}$.

3. A method for transmitting data comprising a plurality of data words via a medium having a maximum time between data transitions of $T_{max}$ and a minimum time between data transitions of $T_{min}$, each data word being composed of a plurality of 1's and 0's, including forming a prepended data word by prepending a unique signal to each data word for indicating the start of a transmitted data word (60), and serially transmitting data words one bit at a time (62) each transmitted bit having a uniform length greater than $T_{min}$, characterised in that the method comprises :

(a) selecting a maximum number of permitted consecutive 1's, whereby the maximum number of permitted consecutive 1's in a data word are transmitted in a time of less than $T_{max}$;

(b) selecting a maximum number of permitted consecutive 0's, whereby the maximum number of permitted consecutive 0's in a data word are transmitted in a time of less than $T_{max}$;

(c) counting the number of consecutive 1's in each prepended data word for transmission (76) and ensuring transmission of no more than said maximum number of consecutive 1's by inserting 0's into said prepended data word (80) to convert strings of 1's therein longer than the maximum number of consecutive 1's into at least two shorter strings; and

(d) counting the number of consecutive 0's in each prepended data word for transmission (68) and ensuring transmission of no more than said maximum number of consecutive 0's by inserting 1's into said prepended data word (72) to convert strings of 0's therein longer than said maximum number of consecutive 0's into at least two shorter strings.

4. A method for transmitting data according to claim 3, wherein said unique signal prepended to each data word indicating the start of a transmitted data word consists of the greatest integral number of consecutive 1's that can be transmitted in a time less than $T_{max}$ followed by a single 0, and wherein:

(a) said step of selecting said maximum number of permitted consecutive 1's selects an integral number less than said number of consecutive 1's of said unique signal;

(b) said step of selecting said maximum number of permitted consecutive 0's selects a greatest integral number of consecutive 0's that can be transmitted in a time less than $T_{max}$.

5. A method for receiving data comprising a plurality of data words via a medium having a maximum time between data transitions of $T_{max}$ and a minimum time between data transitions of $T_{min}$, each data word being composed of a plurality of 1's and 0's and having a unique signal to each data word for indicating the start of a transmitted data word prepended thereto (60), receiving said serially transmitted data words (92), searching received data for said unique signal (90), and removing said unique signal from the received data words (90), characterised in that the method comprises :

(a) selecting a maximum number of permitted consecutive 1's, whereby the maximum number of permitted consecutive 1's in a data word are transmitted in a time of less than $T_{max}$;

(b) selecting a maximum number of permitted consecutive 0's, whereby the maximum number of permitted consecutive 0's in a data word are transmitted in a time of less than $T_{max}$;

(c) counting the number of consecutive 1's in the received data words (104) and removing a next bit following the receipt of said maximun number of consecutive 1's (106, 108); and

(d) counting the number of consecutive 0's in the received data words (96) and removing a next bit following receipt of said maximum number of consecutive 0's (98, 100).

6. The method for receiving data of claim 5, wherein said unique signal prepended to each data word indicating the start of a transmitted data word consists of the greatest integral number of consecutive 1's that can be transmitted in a time less than $T_{max}$ followed by a single 0, and wherein:

(a) said step of selecting said maximum number of permitted consecutive 1's selects an integral number less than said number of consecutive 1's of said unique signal;

(b) said step of selecting said maximum number of permitted consecutive 0's selects a greatest integral number of consecutive 0's that can be transmitted in a time less than $T_{max}$.

7. A system for transmitting and receiving data comprising a plurality of data words via a medium having a maximum time between data transitions of $T_{max}$ and a minimum time between data transitions of $T_{min}$, each data word being composed of a plurality of 1's and 0's, including means for forming a prepended data word by prepending a unique signal to each data word for indicating the start of a transmitted data word (60), means (12) for serially transmitting data words one bit at a time (62) each transmitted bit having a uniform length greater than $T_{min}$, means (16) for receiving said serially transmitted data words (92), means for searching received data for said unique signal (90), and removing said unique signal from the received data words (90), characterised in that the system comprises:

(a) means (32) for counting the number of consecutive 1's in each prepended data word for transmission (76) and for ensuring transmission of no more than a maximum number of consecutive 1's by inserting 0's into said prepended data word (80) to convert strings of 1's therein longer than the maximum number of consecutive 1's into at least two shorter strings, the maximum number of permitted consecutive 1's having been chosen so that the maximum number of permitted consecutive 1's in a data word are transmitted in a time of less than $T_{max}$;

(b) means (30) for counting the number of consecutive 0's in each prepended data word for transmission (68) and for ensuring transmission of no more than said maximum number of consecutive 0's by inserting 1's into said prepended data word (72) to convert strings of 0's therein longer than said maximum number of consecutive 0's into at least two shorter strings the maximum number of permitted consecutive 0's having been chosen so that the maximum number of permitted consecutive 0's in a data word are transmitted in a time of less than $T_{max}$;

(c) means for counting the number of consecutive 1's in the received data words (104) and for removing a next bit following the receipt of said maximum number of consecutive 1's (106, 108); and

(d) means for counting the number of consecutive 0's in the received data words (96) and removing a next bit following receipt of said maximum number of consecutive 0's (98, 100).

8. A system for transmitting data comprising a plurality of data words via a medium having a maximum time between data transitions of $T_{max}$ and a minimum time between data transitions of $T_{min}$, each data word being composed of a plurality of 1's and 0's, including means for forming a prepended data word by prepending a unique signal to each data word for indicating the start of a transmitted data word (60), and means (12) for serially transmitting data words one bit at a time (62) each transmitted bit having a uniform length greater than $T_{min}$, characterised in that the system comprises:

(a) means (32) for counting the number of consecutive 1's in each prepended data word for transmission (76) and for ensuring transmission of no more than a maximum number of consecutive 1's by inserting 0's into said prepended data word (80) to convert strings of 1's therein longer than the maximum number of consecutive 1's into at least two shorter strings, the maximum number of permitted consecutive 1's, having been chosen so that the maximum number of permitted consecutive 1's in a data word are transmitted in a time of less than $T_{max}$;

(b) means (30) for counting the number of consecutive 0's in each prepended data word for transmission (68) and for ensuring transmission of no more than a maximum number of consecutive 0's by inserting 1's into said prepended data word (72) to convert strings of 0's therein longer than said maximum number of consecutive 0's into at least two shorter strings, the maximum number of permitted consecutive 0's, having been chosen so that the maximum number of permitted consecutive 0's in a data word are transmitted in a time of less than $T_{max}$.

9. A system for receiving data comprising a plurality of data words via a medium having a maximum time between data transitions of $T_{max}$ and a minimum time between data transitions of $T_{min}$, each data word composed of a plurality of 1's and 0's and having a unique signal to each data word for indicating the start of a transmitted data word prepended thereto (60), means (16) for receiving said serially transmitted data words (92), means for searching received data for said unique signal (90), and removing said unique signal from the received data words (90), characterised in that the system comprises:

(a) means for counting the number of consecutive 1's in the received data words (104) and for removing a next bit following the receipt of a maximum number of consecutive 1's (106, 108), the maximum number of permitted consecutive 1's, having been chosen so that the maximum number of permitted consecutive 1's in a data word are transmitted in a time of less than $T_{max}$;

(b) means for counting the number of consecutive 0's in the received data words (96) and for removing a next bit following receipt of said maximum number of consecutive 0's (98, 100), the maximum number of permitted consecutive 0's, having been chosen so that the maximum number of permitted consecutive 0's in a data word are transmitted in a time of less than $T_{max}$.

## Patentansprüche

1. Verfahren zum Übertragen und Empfangen von. Daten, die mehrere Datenwörter umfassen, über ein Medium mit einer maximalen Zeitdauer $T_{max}$ zwischen Datenübergängen und einer minimalen Zeitdauer $T_{min}$ zwischen Datenübergängen, wobei jedes Datenwort aus mehreren Einsen und Nullen besteht, bei welchem ein mit einem Vorsatz versehenes Datenwort dadurch gebildet wird, daß jedem Datenwort ein eindeutiges Signal vorgesetzt wird, um den Beginn eines übertragenen Datenwortes anzuzeigen (60), Datenwörter bitweise seriell übertragen werden (62), wobei jedes übertragene Bit eine einheitliche Länge hat, die größer als $T_{min}$ ist, die seriell übertragenen Datenwörter empfangen werden (92), die empfangenen Daten auf das eindeutige Signal hin abgesucht werden (90), und das eindeutige Signal aus den empfangenen Datenwörtern entfernt wird (90), dadurch gekennzeichnet, daß das Verfahren umfaßt:

(a) es wird eine maximale Anzahl zulässiger aufeinanderfolgender Einsen ausgewählt, wobei die maximale Anzahl zulässiger aufeinanderfolgender Einsen in einem Datenwort in einer Zeitdauer übertragen wird, die kleiner als $T_{max}$ ist;
(b) es wird eine maximale Anzahl zulässiger aufeinanderfolgender Nullen ausgewählt, wobei die maximale Anzahl zulässiger aufeinanderfolgender Nullen in einem Datenwort in einer Zeitdauer übertragen wird, die kleiner als $T_{max}$ ist;
(c) es wird die Anzahl aufeinanderfolgender Einsen in jedem mit einem Vorsatz versehenen Datenwort für die Übertragung gezählt (76), und es wird sichergestellt, daß nicht mehr als die maximale Anzahl aufeinanderfolgender Einsen übertragen wird, indem Nullen in die mit einem Vorsatz versehenen Datenwörter eingefügt werden (80), um Folgen mit einer Anzahl von Einsen, die größer als die maximale Anzahl aufeinanderfolgender Einsen ist, in wenigstens zwei kürzere Folgen umzuwandeln;
(d) es wird die Anzahl aufeinanderfolgender Nullen in jedem mit einem Vorsatz versehenen Datenwort für die Übertragung gezählt (68), und es wird sichergestellt, daß nicht mehr als die maximale Anzahl aufeinanderfolgender Nullen übertragen wird, indem Einsen in die mit einem Vorsatz versehenen Datenwörter eingefügt werden (72), um Folgen mit einer Anzahl von Nullen, die größer als die maximale Anzahl aufeinanderfolgender Nullen ist, in wenigstens zwei kürzere Folgen umzuwandeln;
(e) es wird die Anzahl aufeinanderfolgender Einsen in den empfangenen Datenwörtern gezählt (104) und ein nächstes Bit entfernt, das dem Empfang der maximalen Anzahl aufeinanderfolgender Einsen folgt (106, 108); und
(f) es wird die Anzahl aufeinanderfolgender Nullen in den empfangenen Datenwörtern gezählt (96) und ein nächstes Bit entfernt, das dem Empfang der maximalen Anzahl aufeinanderfolgender Nullen folgt (98, 100).

2. Verfahren zum Übertragen und Empfangen von Daten nach Anspruch 1, bei dem das eindeutige Signal, das jedem Datenwort vorgesetzt ist und den Beginn eines übertragenen Datenwortes anzeigt, aus einer ganzzahligen Anzahl aufeinanderfolgender Einsen, die in einer Zeitdauer übertragen werden kann, die kleiner als $T_{max}$ ist, gefolgt von einer einzigen Null, besteht, und bei dem:

(a) der Schritt des Auswählens der maximalen Anzahl zulässiger aufeinanderfolgender Einsen eine ganzzahlige Anzahl auswählt, die kleiner als die Anzahl aufeinanderfolgender Einsen des eindeutigen Signals ist; und
(b) der Schritt des Auswählens der maximalen Anzahl zulässiger aufeinanderfolgender Nullen eine größte ganzzahlige Anzahl aufeinanderfolgender Nullen auswählt, die in einer zeitdauer übertragen werden kann, die kleiner als $T_{max}$ ist.

3. Verfahren zum Übertragen von Daten, die mehrere Datenwörter umfassen, über ein Medium mit einer maximalen Zeitdauer $T_{max}$ zwischen Datenübergängen und einer minimalen Zeitdauer $T_{min}$ zwischen Datenübergängen, wobei jedes Datenwort aus mehreren Einsen und Nullen besteht, bei welchem ein mit einem Vorsatz versehenes Datenwort dadurch gebildet wird, daß jedem Datenwort ein eindeutiges Signal vorgesetzt wird, um den Beginn eines übertragenen Datenwortes anzuzeigen (60), und Datenwörter bitweise seriell übertragen werden (62), wobei jedes übertragene Bit eine einheitliche Länge hat, die größer als $T_{min}$ ist, dadurch gekennzeichnet, daß das Verfahren umfaßt:

(a) es wird eine maximale Anzahl zulässiger aufeinanderfolgender Einsen ausgewählt, wobei die maximale Anzahl zulässiger aufeinanderfolgender Einsen in einem Datenwort in einer Zeitdauer übertragen wird, die kleiner als $T_{max}$ ist;
(b) es wird eine maximale Anzahl zulässiger aufeinanderfolgender Nullen ausgewählt, wobei die maximale Anzahl zulässiger aufeinanderfolgender Nullen in einem Datenwort in einer Zeitdauer übertragen wird, die kleiner als $T_{max}$ ist;
(c) es wird die Anzahl aufeinanderfolgender Einsen in jedem mit einem Vorsatz versehenen Datenwort für die Übertragung gezählt (76), und es wird sichergestellt, daß nicht mehr als die maximale Anzahl aufeinanderfolgender Einsen übertragen wird, indem Nullen in die mit einem Vorsatz versehenen Datenwörter eingefügt werden (80), um Folgen mit einer Anzahl von Einsen, die größer als die maximale Anzahl aufeinanderfolgender Einsen ist, in wenigstens zwei kürzere Folgen umzuwandeln;
(d) es wird die Anzahl aufeinanderfolgender Nullen in jedem mit einem Vorsatz versehenen Datenwort für die Übertragung gezählt (68), und es wird sichergestellt, daß nicht mehr als die maximale Anzahl aufeinanderfolgender Nullen übertragen wird, indem Einsen in die mit einem Vorsatz versehenen Datenwörter eingefügt werden (72), um Folgen mit einer Anzahl von Nullen, die größer als die maximale Anzahl aufeinanderfolgender Nullen ist, in wenigstens zwei kürzere Folgen umzuwandeln.

4. Verfahren zum Übertragen von Daten nach Anspruch 3, bei dem das eindeutige Signal, das jedem Datenwort vorgesetzt ist und den Beginn eines übertragenen Datenwortes anzeigt, aus einer ganzzahligen Anzahl aufeinanderfolgender Einsen, die in einer Zeitdauer übertragen werden können, die kleiner als $T_{max}$ ist, gefolgt von einer einzigen Null, besteht, und bei dem:

(a) der Schritt des Auswählens der maximalen Anzahl zulässiger aufeinanderfolgender Einsen eine ganzzahlige Anzahl auswählt, die kleiner als die Anzahl aufeinanderfolgender Einsen des eindeutigen Signals ist; und
(b) der Schritt des Auswählens der maximalen Anzahl zulässiger aufeinanderfolgender Nullen eine größte ganzzahlige Anzahl aufeinanderfolgender Nullen auswählt, die in einer Zeitdauer übertragen werden kann, die kleiner als $T_{max}$ ist.

5. Verfahren zum Empfangen von Daten, die mehrere Datenwörter umfassen, über ein Medium mit einer maximalen Zeitdauer $T_{max}$ zwischen Datenübergängen und einer minimalen Zeitdauer $T_{min}$ zwischen Datenübergängen, wobei jedes Datenwort aus mehreren Einsen und Nullen besteht und jedem Datenwort ein eindeutiges Signal vorgesetzt ist, um den Beginn eines übertragenen Datenwortes anzuzeigen (60), bei welchem die seriell übertragenen Datenwörter empfangen werden (92), die empfangenen Daten auf das eindeutige Signal hin abgesucht werden (90), und das eindeutige Signal aus den empfangenen Datenwörtern entfernt wird (90), dadurch gekennzeichnet, daß das Verfahren umfaßt:

(a) es wird eine maximale Anzahl zulässiger aufeinanderfolgender Einsen ausgewählt, wobei die maximale Anzahl zulässiger aufeinanderfolgender Einsen in einem Datenwort in einer Zeitdauer übertragen wird, die kleiner als $T_{max}$ ist;
(b) es wird eine maximale Anzahl zulässiger aufeinanderfolgender Nullen ausgewählt, wobei die maximale Anzahl zulässiger aufeinanderfolgender Nullen in einem Datenwort in einer Zeitdauer übertragen wird, die kleiner als Tmax ist;
(c) es wird die Anzahl aufeinanderfolgender Einsen in den empfangenen Datenwörtern gezählt (104) und ein nächstes Bit entfernt, das dem Empfang der maximalen Anzahl aufeinanderfolgender Einsen folgt (106, 108); und
(d) es wird die Anzahl aufeinanderfolgender Nullen in den empfangenen Datenwörtern gezählt (96) und ein nächstes Bit entfernt, das dem Empfang der maximalen Anzahl aufeinanderfolgender Nullen folgt (98, 100).

6. Verfahren zum Empfangen von Daten nach Anspruch 5, bei dem das eindeutige Signal, das jedem Datenwort vorgesetzt ist und den Beginn eines übertragenen Datenwortes anzeigt, aus der größten ganzzahligen Anzahl aufeinanderfolgender Einsen, die in einer Zeitdauer übertragen werden können, die kleiner als $T_{max}$ ist, gefolgt von einer einzigen Null, besteht, und bei dem:

(a) der Schritt des Auswählens der maximalen Anzahl zulässiger aufeinanderfolgender Einsen eine ganzzahlige Anzahl auswählt, die kleiner als die Anzahl aufeinanderfolgender Einsen des eindeutigen Signals ist; und
(b) der Schritt des Auswählens der maximalen Anzahl zulässiger aufeinanderfolgender Nullen eine größte ganzzahlige Anzahl aufeinanderfolgender Nullen auswählt, die in einer Zeitdauer übertragen werden kann, die kleiner als $T_{max}$ ist.

7. System zum Übertragen und Empfangen von Daten, die mehrere Datenwörter umfassen, über ein Medium mit einer maximalen Zeitdauer $T_{max}$ zwischen Datenübergängen und einer minimalen Zeitdauer $T_{min}$ zwischen Datenübergängen, wobei jedes Datenwort aus mehreren Einsen und Nullen besteht, mit Mitteln, um ein mit einem Vorsatz versehenes Datenwort zu bilden, indem jedem Datenwort ein eindeutiges Signal vorgesetzt wird, um den Beginn eines übertragenen Datenwortes anzuzeigen (60), Mitteln (12), um die Datenwörter bitweise seriell zu übertragen (62), wobei jedes übertragene Bit eine einheitliche Länge hat, die größer als $T_{min}$ ist, Mitteln (16), um die seriell übertragenen Datenwörter zu empfangen (92), Mitteln, um die empfangenen Daten auf das eindeutige Signal hin abzusuchen (90) und um das eindeutige Signal aus den empfangenen Datenwörtern zu entfernen (90), dadurch gekennzeichnet, daß das System umfaßt:

(a) Mittel (32), um die Anzahl aufeinanderfolgender Einsen in jedem mit einem Vorsatz versehenen Datenwort für die Übertragung zu zählen (76) und um sicherzustellen, daß nicht mehr als eine maximale Anzahl aufeinanderfolgender Einsen übertragen wird, indem Nullen in die mit einem Vorsatz versehenen Datenwörter eingefügt werden (80), um Folgen mit einer Anzahl von Einsen, die größer als die maximale Anzahl aufeinanderfolgender Einsen ist, in wenigstens zwei kürzere Folgen umzuwandeln; wobei die maximale Anzahl zulässiger aufeinanderfolgender Einsen so ausgewählt worden ist, daß die maximale Anzahl zulässiger aufeinanderfolgender Einsen in einem Datenwort in einer Zeitdauer übertragen wird, die kleiner als $T_{max}$ ist;

(b) Mittel (30), um die Anzahl aufeinanderfolgender Nullen in jedem mit einem Vorsatz versehenen Datenwort für die Übertragung zu zählen (68) und um sicherzustellen, daß nicht mehr als die maximale Anzahl aufeinanderfolgender Nullen übertragen wird, indem Einsen in die mit einem Vorsatz versehenen Datenwörter eingefügt werden (72), um Folgen mit einer Anzahl von Nullen, die größer als die maximale Anzahl aufeinanderfolgender Nullen ist, in wenigstens zwei kürzere Folgen umzuwandeln; wobei die maximale Anzahl zulässiger aufeinanderfolgender Nullen so ausgewählt worden ist, daß die maximale Anzahl zulässiger aufeinanderfolgender Nullen in einem Datenwort in einer Zeitdauer übertragen wird, die kleiner als $T_{max}$ ist;

(c) Mittel, um die Anzahl aufeinanderfolgender Einsen in den empfangenen Datenwörtern zu zählen (104) und um ein nächstes Bit zu entfernen, das dem Empfang der maximalen Anzahl aufeinanderfolgender Einsen folgt (106, 108); und

(d) Mittel, um die Anzahl aufeinanderfolgender Nullen in den empfangenen Datenwörtern zu zählen (96) und um ein nächstes Bit zu entfernen, das dem Empfang der maximalen Anzahl aufeinanderfolgender Nullen folgt (98, 100).

8. System zum Übertragen von Daten, die mehrere Datenwörter umfassen, über ein Medium mit einer maximalen Zeitdauer $T_{max}$ zwischen Datenübergängen und einer minimalen Zeitdauer $T_{min}$ zwischen Datenübergängen, wobei jedes Datenwort aus mehreren Einsen und Nullen besteht, mit Mitteln, um ein mit einem Vorsatz versehenes Datenwort zu bilden, indem jedem Datenwort ein eindeutiges Signal vorgesetzt wird, um den Beginn eines übertragenen Datenwortes anzuzeigen (60), und Mitteln (12), um die Datenwörter bitweise seriell zu übertragen (62), wobei jedes übertragene Bit eine einheitliche Länge hat, die größer als $T_{min}$ ist, dadurch gekennzeichnet, daß das System umfaßt:

(a) Mittel (32), um die Anzahl aufeinanderfolgender Einsen in jedem mit einem Vorsatz versehenen Datenwort für die Übertragung zu zählen (76) und um sicherzustellen, daß nicht mehr als eine maximale Anzahl aufeinanderfolgender Einsen übertragen wird, indem Nullen in die mit einem vorsatz versehenen Datenwörter eingefügt werden (80), um Folgen mit einer Anzahl von Einsen, die größer als die maximale Anzahl aufeinanderfolgender Einsen ist, in wenigstens zwei kürzere Folgen umzuwandeln; wobei die maximale Anzahl zulässiger aufeinanderfolgender Einsen so ausgewählt worden ist, daß die maximale Anzahl zulässiger aufeinanderfolgender Einsen in einem Datenwort in einer Zeitdauer übertragen wird, die kleiner als $T_{max}$ ist; und

(b) Mittel (30), um die Anzahl aufeinanderfolgender Nullen in jedem mit einem Vorsatz versehenen Datenwort für die Übertragung zu zählen (68) und um sicherzustellen, daß nicht mehr als die maximale Anzahl aufeinanderfolgender Nullen übertragen wird, indem Einsen in die mit einem Vorsatz versehenen Datenwörter eingefügt werden (72), um Folgen mit einer Anzahl von Nullen, die größer als die maximale Anzahl aufeinanderfolgender Nullen ist, in wenigstens zwei kürzere Folgen umzuwandeln; wobei die maximale Anzahl zulässiger aufeinanderfolgender Nullen so ausgewählt worden ist, daß die maximale Anzahl zulässiger aufeinanderfolgender Nullen in einem Datenwort in einer Zeitdauer übertragen wird, die kleiner als $T_{max}$ ist.

9. System zum Empfangen von Daten, die mehrere Datenwörter umfassen, über ein Medium mit einer maximalen Zeitdauer $T_{max}$ zwischen Datenübergängen und einer minimalen Zeitdauer $T_{min}$ zwischen Datenübergängen, wobei jedes Datenwort aus mehreren Einsen und Nullen besteht und jedem Datenwort ein eindeutiges Signal vorgesetzt ist, um den Beginn eines übertragenen Datenwortes anzuzeigen (60) mit Mitteln (16), um die seriell übertragenen Datenwörter zu empfangen (92), und Mitteln, um die empfangenen Daten auf das eindeutige Signal hin abzusuchen (90) und um das eindeutige Signal aus den empfangenen Datenwörtern zu entfernen (90), dadurch gekennzeichnet, daß das System umfaßt:

(a) Mittel, um die Anzahl aufeinanderfolgender Einsen in den empfangenen Datenwörtern zu zählen (104) und um ein nächstes Bit zu entfernen, das dem Empfang der maximalen Anzahl aufeinanderfolgender Einsen folgt (106, 108), wobei die maximale Anzahl zulässiger aufeinanderfolgender Einsen so ausgewählt worden ist, daß die maximale Anzahl zulässiger aufeinanderfolgender Einsen in einem Datenwort in einer Zeitdauer übertragen wird, die kleiner als $T_{max}$ ist; und
(b) Mittel, um die Anzahl aufeinanderfolgender Nullen in den empfangenen Datenwörtern zu zählen (96) und um ein nächstes Bit zu entfernen, das dem Empfang der maximalen Anzahl aufeinanderfolgender Nullen folgt (98, 100), wobei die maximale Anzahl zulässiger aufeinanderfolgender Nullen so ausgewählt worden ist, daß die maximale Anzahl zulässiger aufeinanderfolgender Nullen in einem Datenwort in einer Zeitdauer übertragen wird, die kleiner als Tmax ist.

**Revendications**

1. Procédé pour émettre et recevoir des données comprenant une pluralité de mots de données par l'intermédiaire d'un support ayant une durée maximale de $T_{max}$ entre des transitions de données et une durée minimale de $T_{min}$ entre des transitions de données, chaque mot de données étant composé d'une pluralité de "1" et de "0", consistant à former un mot préfixé de données en ajoutant un signal unique devant chaque mot de données pour indiquer le début d'un mot émis de données (60), émettre en série des mots de données bit par bit (62), chaque mot émis ayant une longueur uniforme supérieure à $T_{min}$, recevoir lesdits mots de données (92) émis en série, chercher dans les données reçues ledit signal unique (90), et retirer ledit signal unique des mots reçus de données (90), caractérisé en ce que ce procédé comprend les étapes consistant à :

(a) sélectionner un nombre maximal de "1" consécutifs autorisés, au moyen de quoi le nombre maximal de "1" consécutifs dans un mot de données est émis dans un temps inférieur à $T_{max}$ :
(b) sélectionner un nombre maximal de "0" consécutifs autorisés, au moyen de quoi le nombre maximal de "0" consécutifs dans un mot de données est émis dans un temps inférieur à $T_{max}$ ;
(c) compter le nombre de "1' consécutifs dans chaque mot préfixé de données pour une émission (76) et assurer une émission d'un nombre non supérieur audit maximum de "1" consécutifs en insérant des "0" dans ledit mot préfixé de données (80) pour y convertir des chaînes de "1" plus longues que le nombre maximal de "1" consécutifs en au moins deux chaînes plus courtes ;
(d) compter le nombre de "0" consécutifs dans chaque mot préfixé de données pour une émission (68) et assurer une émission d'un nombre non supérieur audit maximum de "0" consécutifs en insérant des "1" dans ledit mot préfixé de données (72) pour y convertir des chaînes de "0" plus longues que ledit nombre maximal de "0" consécutifs en au moins deux chaînes plus courtes ;
(e) compter le nombre de "1" consécutifs dans les mots reçus de données (104) et retirer un bit suivant après la réception dudit nombre maximal de "1" consécutifs (106, 108) ; et
(f) compter le nombre de "0" consécutifs dans les mots reçus de données (96) et retirer un bit suivant après la réception dudit nombre maximal de "0" consécutifs (98, 100).

2. Procédé pour émettre et recevoir des données selon la revendication 1, dans lequel ledit signal unique ajouté avant chaque mot de données indiquant le début d'un mot émis de données consiste en un nombre entier de "1. consécutifs qui peuvent être émis en une durée inférieure à $T_{max}$ suivis d'un seul zéro, et dans lequel :

(a) ladite étape consistant à sélectionner ledit nombre maximal de "1" consécutifs autorisés sélectionne un nombre entier inférieur audit nombre de "1" consécutifs dudit signal unique ;

(b) ladite étape consistant à sélectionner ledit nombre maximal de "0" consécutifs autorisés sélectionne le plus grand nombre entier de "0" consécutifs qui peuvent être émis pendant une durée inférieure à $T_{max}$.

3. Procédé pour émettre des données comprenant une pluralité de mots de données par l'intermédiaire d'un support ayant un durée maximale de $T_{max}$ entre des transitions de données et une durée minimale de $T_{min}$ entre des transitions de données, chaque mot de données étant composé d'une pluralité de "1" et de "0", consistant à former un mot préfixé de données en ajoutant un signal unique devant chaque mot de données pour indiquer le début d'un mot émis de données (60), et émettre en série des mots de données bit par bit (62), chaque bit émis ayant une longueur uniforme supérieure à $T_{min}$, caractérisé en ce que le procédé comprend les étapes suivantes :

> (a) sélectionner un nombre maximal de "1" consécutifs autorisés, au moyen de quoi le nombre maximal de "1" consécutifs dans un mot de données est émis dans un temps inférieur à $T_{max}$ ;
> (b) sélectionner un nombre maximal de "0" consécutifs autorisés, au moyen de quoi le nombre maximal de "0" consécutifs dans un mot de données est émis dans un temps inférieur à $T_{max}$ ;
> (c) compter le nombre de "1" consécutifs dans chaque mot préfixé de données pour une émission (76) et assurer une émission d'un nombre non supérieur audit maximum de "1" consécutifs en insérant des "0" dans ledit mot préfixé de données (80) pour y convertir des chaînes de "1" plus longues que le nombre maximal de "1" consécutifs en au moins deux chaînes plus courtes ; et
> (d) compter le nombre de "0" consécutifs dans chaque mot préfixé de données pour une émission (68) et assurer une émission d'un nombre non supérieur audit maximum de "0' consécutifs en insérant des "1" dans ledit mot préfixé de données (72) pour convertir des chaînes de "0" plus longues que ledit nombre maximal de "0" consécutifs en au moins deux chaînes plus courtes.

4. Procédé pour émettre des données selon la revendication 3, dans lequel ledit signal unique ajouté avant chaque mot de données indiquant le début d'un mot émis de données consiste en le plus grand nombre entier de "1" consécutifs qui peuvent être émis pendant une durée inférieure à $T_{max}$ suivis d'un seul zéro, et dans lequel :

(a) ladite étape consistant à sélectionner ledit nombre maximal de "1" consécutifs autorisés sélectionne un nombre entier inférieur audit nombre de "1" consécutifs dudit signal unique :
(b) ladite étape consistant à sélectionner ledit nombre maximal de "0" consécutifs autorisés sélectionne le plus grand nombre entier de "0" consécutifs qui peuvent être émis pendant une durée inférieure à $T_{max}$.

5. Procédé pour recevoir des données comprenant une pluralité de mots de données par l'intermédiaire d'un support ayant un durée maximale de $T_{max}$ entre des transitions de données et une durée minimale de $T_{min}$ entre des transitions de données, chaque mot de données étant composé d'une pluralité de "1" et de "0" et ayant à chaque mot de données un signal unique pour indiquer le début d'un mot émis de données (60) qui est ajouté devant lui, consistant à recevoir lesdits mots de données émis en série (92), chercher dans les données reçues ledit signal unique (90) et retirer ledit signal unique des mots reçus de données (90), caractérisé en ce que le procédé comprend les étapes consistant à :

> (a) sélectionner un nombre maximal de "1" consécutifs autorisés, au moyen de quoi le nombre maximal de "1" consécutifs dans un mot de données est émis dans un temps inférieur à $T_{max}$ ;
> (b) sélectionner un nombre maximal de "0" consécutifs autorisés, au moyen de quoi le nombre maximal de "0" consécutifs dans un mot de données est émis dans un temps inférieur à $T_{max}$ ;
> (c) compter le nombre de "1" consécutifs dans les mots reçus de données (104) et retirer un bit suivant après la réception dudit nombre maximal de "1" consécutifs (106, 108) ; et
> (d) compter le nombre de "0" consécutifs dans les mots reçus de données (96) et retirer un bit suivant après la réception dudit nombre maximal de "0" consécutifs (98, 100).

6. Procédé pour recevoir des données selon la revendication 5, dans lequel ledit signal unique ajouté avant chaque mot de données indiquant le début d'un mot émis de données consiste en le plus grand nombre entier de "1" consécutifs qui peuvent être émis pendant une durée inférieure à $T_{max}$ suivis d'un seul zéro, et dans lequel :

(a) ladite étape consistant à sélectionner ledit nombre maximal de "1" consécutifs autorisés sélectionne un nombre entier inférieur audit nombre de "1" consécutifs dudit signal unique ;
(b) ladite étape consistant à sélectionner ledit nombre maximal de "0" consécutifs autorisés sélectionne le plus grand nombre entier de "0" consécutifs qui peuvent être émis pendant une durée inférieure à $T_{max}$.

7. Système pour émettre et recevoir des données comprenant une pluralité de mots de données par l'intermédiaire d'un support ayant un durée maximale de $T_{max}$ entre des transitions de données et une durée minimale de $T_{min}$ entre des transitions de données, chaque mot de données étant composé d'une pluralité de "1" et de "0", comprenant des moyens pour former un mot préfixé de données en ajoutant un signal unique devant chaque mot de données pour indiquer le début d'un mot émis de données (60), des moyens (12) pour émettre en série lesdits mots de données bits par bit (62), chaque bit émis ayant une longueur uniforme supérieure à $T_{min}$, des moyens (16) pour recevoir lesdits mots de données émis en série (92), des moyens pour chercher dans les données reçues ledit signal unique (90) et retirer ledit signal unique des mots reçus de données (90), caractérisé en ce que le système comprend :

(a) des moyens (32) pour compter le nombre de "1" consécutifs dans chaque mot préfixé de données pour une émission (76) et assurer une émission d'un nombre non supérieur audit maximum de "1" consécutifs en insérant des "0" dans ledit mot préfixé de données (80) pour y convertir des chaînes de "1" plus longues que le nombre maximal de "1" consécutifs en au moins deux chaînes plus courtes. le nombre maximal de "1" consécutifs autorisés ayant été choisi de sorte que le nombre maximal de "1" consécutifs autorisés dans un mot de données soit émis en un temps inférieur à $T_{max}$;
(b) des moyens (30) pour compter le nombre de "0" consécutifs dans chaque mot préfixé de données pour une émission (68) et assurer une émission d'un nombre non supérieur audit maximum de "0" consécutifs en insérant des "1" dans ledit mot préfixé de données (72) pour y convertir des chaînes de "0" plus longues que ledit nombre maximal de "0" consécutifs en au moins deux chaînes plus courtes, le nombre maximal de "0" consécutifs autorisés ayant été choisi de sorte que le nombre maximal de "0" consécutifs autorisés dans un mot de données soit émis en un temps inférieur à $T_{max}$;
(c) des moyens pour compter le nombre de "1" consécutifs dans les mots reçus de données (104) et retirer un bit suivant après la réception dudit nombre maximal de "1" consécutifs (106, 108) ; et
(d) des moyens pour compter le nombre de "0" consécutifs dans les mots reçus de données (96) et retirer un bit suivant après la réception dudit nombre maximal de "0" consécutifs (98, 100).

8. Système pour émettre des données comprenant une pluralité de mots de données par l'intermédiaire d'un support ayant un durée maximale de $T_{max}$ entre des transitions de données et une durée minimale de $T_{min}$ entre des transitions de données, chaque mot de données étant composé d'une pluralité de "1" et de "0", comprenant des moyens pour former un mot préfixé de données en ajoutant un signal unique devant chaque mot de données pour indiquer le début d'un mot émis de données (60), et des moyens (12) pour émettre en série lesdits mots de données bit par bit (62), chaque bit émis ayant une longueur uniforme supérieure à $T_{min}$, caractérisé en ce que le système comprend :

(a) des moyens (32) pour compter le nombre de "1" consécutifs dans chaque mot préfixé de données pour une émission (76) et assurer une émission d'un nombre non supérieur audit maximum de "1" consécutifs en insérant des "0" dans ledit mot préfixé de données (80) pour y convertir des chaînes de "1" plus longues que le nombre maximal de "1" consécutifs en au moins deux chaînes plus courtes, le nombre maximal de "1" consécutifs autorisés ayant été choisi de sorte que le nombre maximal de "1" consécutifs autorisés dans un mot de données soit émis en un temps inférieur à $T_{max}$;
(b) des moyens (30) pour compter le nombre de "0" consécutifs dans chaque mot préfixé de données pour une émission (68) et assurer une émission d'un nombre non supérieur à un maximum de "0" consécutifs en insérant des "1" dans ledit mot préfixé de données (72) pour y convertir des chaînes de "0" plus longues que ledit nombre maximal de "0" consécutifs en au moins deux chaînes plus courtes, le nombre maximal de "0" consécutifs autorisés ayant été choisi de sorte que le nombre maximal de "0" consécutifs autorisés dans un mot de données soit émis en un temps inférieur à $T_{max}$.

9. Système pour recevoir des données comprenant une pluralité de mots de données par l'intermédiaire d'un support ayant un durée maximale de $T_{max}$ entre des transitions de données et une durée minimale de $T_{min}$, entre des transitions de données, chaque mot de données étant composé d'une pluralité de "1" et de "0" et ayant un signal unique ajouté devant chaque mot de données (60) pour indiquer le début du mot de données transmises qui est ajouté devant lui, des moyens (16) pour recevoir lesdits mots de données émis en série (92), des moyens pour chercher dans lesdites données reçues ledit signal unique (90) et retirer ledit signal unique desdits mots reçus de données (90), caractérisé en ce que le système comprend :

(a) des moyens pour compter le nombre de "1" consécutifs dans les mots reçus de données (104) et pour retirer un bit suivant après la réception d'un nombre maximal de "1" consécutifs (106, 108), le nombre maximal de "1" consécutifs autorisés ayant été choisi de sorte que le nombre maximal de "1" consécutifs autorisés dans un mot de données soit émis en un temps inférieur à $T_{max}$;

(b) des moyens pour compter le nombre de "0" consécutifs dans les mots reçus de données (96) et pour retirer un bit suivant après la réception dudit nombre maximal de "0" consécutifs (98, 100), le nombre maximal de "0" consécutifs autorisés ayant été choisi de sorte que le nombre maximal de "0" consécutifs autorisés dans un mot de données soit émis en un temps inférieur à $T_{max}$.

Fig. 1

Fig. 6

EP 0 364 170 B1

Fig. 2

EP 0 364 170 B1

Fig. 3

Fig. 4

*Fig.5*